# EUROPEAN PATENT SPECIFICATION

(11) **EP 3 594 378 B1**
(45) Date of publication and mention of the grant of the patent: **19.06.2024**
(21) Application number: 17900026.0
(22) Date of filing: 29.03.2017
(51) Int. Cl.: H10K 71/16, H10K 85/50, C23C 16/448, C23C 14/22, C23C 14/24, C23C 16/30, C23C 16/455

(54) **APPARATUS FOR PREPARING LARGE-AREA PEROVSKITE THIN FILM**
VORRICHTUNG ZUR HERSTELLUNG EINER GROSSFLÄCHIGEN PEROWSKIT-DÜNNSCHICHT
APPAREIL POUR PRÉPARER UN FILM MINCE DE PÉROVSKITE DE GRANDE SURFACE

(30) Priority: 10.03.2017 WO PCT/CN2017/078529
(43) Date of publication of application: 15.01.2020
(73) Proprietor: Changzhou University, Changzhou, Jiangsu 213164 (CN)
(72) Inventor: DING, Jianning, Changzhou Jiangsu 213164 (CN); WANG, Shubo, Changzhou Jiangsu 213164 (CN); YUAN, Ningyi, Changzhou Jiangsu 213164 (CN); JIA, Xuguang, Changzhou Jiangsu 213164 (CN)
(74) Representative: Balder IP Law, S.L.
(86) International application number: PCT/CN2017/078529
(87) International publication number: WO 2018/161382

(56) References cited:
- CN-A- 101 622 373
- CN-A- 105 386 006
- CN-A- 105 957 970
- CN-U- 205 974 658
- CN-U- 205 974 658
- CN-U- 206 680 573
- JP-A- 2007 146 219
- US-A1- 2004 062 862

## Description

### BACKGROUND OF THE INVENTION

### Field of the Invention

The present invention relates to the technical field of solar cell, and in particular, to a manufacture equipment for large-area perovskite film.

### Description of the Related Art

Perovskite film solar cells develop quickly as next generation of high-efficiency film solar cell. In 2012, a first solid perovskite solar cell was disclosed with the efficiency of 9.7%. Within five years, the efficiency of small-area perovskite film solar cells has reached up to 21%. Currently, some industrial processes such as thermal spray-coating, thermal evaporation, CVD (Chemical Vapor Deposition) and the like have been developed to replace spin-coating process. However, those high-efficiency cells are all manufactured by spin-coating process and cannot be manufactured industrially in a large area.

A related art document JP2007146219A provides a vacuum vapor deposition apparatus capable of performing the vapor deposition of a plurality of dissimilar materials on a member for vapor deposition at a uniform component ratio by moving at least one of the member for vapor deposition and an evaporation source straight. The vacuum vapor deposition apparatus is provided with: an evaporation device for heating and vaporizing first and second dissimilar vapor deposition materials; a glass substrate for performing the vapor deposition of the first and second evaporation material vaporized from the evaporation device in a vacuum vapor deposition container; and a substrate holding and moving device for moving the glass substrate in the x direction. The evaporation device has nozzle sets, arranging a first nozzle cylinder and a second nozzle cylinder close to each other which emit the first and second evaporation materials toward the glass substrate after diffusing the first and second evaporation materials introduced from the evaporation units, by first and second diffusion containers, and the nozzle sets are arranged in line in the crossing direction orthogonal to the moving direction of the glass substrate.

Another related art document CN101622373A provides an apparatus for controlling deposition apparatus. A control apparatus is provided for a deposition apparatus which performs film forming process to a substrate by using a film forming material evaporated at a deposition source. A storage section of the control apparatus stores a plurality of tables indicating relationships between the film forming speeds and carrier gas flow quantities. A table selecting section selects a desired table from among the tables stored in the storage section, based on process conditions. A film formation controller obtains a film forming speed for the substrate, based on a signal outputted from a QCM for detecting the evaporating speed of the film forming material. A carrier gas adjusting section uses data on the relationships between the film forming speeds and the carrier gas flow quantities indicated on the table stored in the storage section, and adjusts the flow quantity of the carrier gas to obtain a desired film forming speed, corresponding to the deviation between the film forming speed obtained by the film forming controller and a target film forming speed.

### SUMMARY OF THE INVENTION

To overcome the defects of the prior art that the perovskite film cell cannot be manufactured industrially in a large area, the present invention provides a manufacture equipment for a large-area perovskite film.

The advantageous technical effects of the present invention includes: in comparison with the prior art, the manufacture equipment for a large-area perovskite film of the present invention can realize industrialized production; with a embedded spray nozzle, reaction species can be sprayed onto a substrate uniformly and controllably in a large area; with raw materials arranged outside a vacuum chamber, continuous production can be conducted without opening the vacuum chamber. Moreover, a gas-carrying process can improve uniformity of the large-area film in comparison with thermal evaporation, and can be controlled easily and has good repeatability in comparison with spin-coating and thermal spray coating and other processes.

To realize the object of the present invention, there is provided a manufacture equipment for a large-area perovskite film, comprising a vacuum chamber provided with a substrate heater therein for accommodating a substrate;
a first evaporation case and a second evaporation case are disposed under the substrate heater in the vacuum chamber, the first evaporation case has an open upper end, the second evaporation case is provided with a plurality of gas pipes vertically disposed on an upper end surface thereof; the first evaporation case is embedded above the second evaporation case, the upper ends of the respective gas pipes penetrate through a bottom surface of the first evaporation case and protrude inside the first evaporation case; a damper is disposed between the first evaporation case and the substrate heater to be opened and closed;
the first evaporation case is connected with a first carrier-gas pipe communicating with an external carrier-gas source; a first raw material heating box is provided on the first carrier-gas pipe, and the first raw material heating box is connected with a first raw material feeding mechanism; a second raw material heating box is provided on the second carrier-gas pipe, and the second raw material heating box is connected with a second raw material feeding mechanism; the raw material feeding mechanisms serve for feeding raw materials to the raw material boxes,
a heat-tracing heater is disposed inside the vacuum chamber, the heat-tracing heater is provided alone surrounding, in a conformal manner, sidewalls and bottom of the first evaporation case and the second evaporation case.

Further, a first gas preheater is provided on the pipeline of the first carrier-gas pipe, and a second gas preheater is provided on the pipeline of the second carrier-gas pipe.

Further, the gas preheater each includes a metal heating body which has a gas stream channel of Peano curve configuration therein.

Further, an orifice plate is provided above the opened upper end of the first evaporation case. The orifice plate is formed with a plurality of first gas pores and a plurality of second gas pores respectively. The first gas pores are provided for evaporated first solid evaporation source passing, and the second gas pores are provided for evaporated second evaporation source passing. Each the first gas pore and the second gas pore are spaced apart and arranged alternately; the upper ends of the respective gas pipes of the second evaporation case are connected with the second gas pores.

Further, a vacuum pump set is provided under the vacuum chamber. The vacuum pump set is communicating with an internal cavity of the vacuum chamber and a butterfly valve is disposed at an inlet of the vacuum pump set. A film thickness gauge is disposed inside the vacuum chamber for measuring the thickness of the substrate.

As described above, the advantageous effects of the present invention lies in: with the manufacture equipment for a large-area perovskite film of the present invention, reaction species are sprayed onto the substrate with carrier-gases via the orifice plates so as to react and produce perovskite film, the uniformity of the perovskite film in large area deposition is greatly improved.

### BRIEF DESCRIPTION OF THE DRAWINGS

Embodiments of the present invention will be described in the following with reference to accompanying drawings.
Fig. 1 is a schematic drawing of the manufacture equipment for a large-area perovskite film according to a first embodiment of the present invention; and
Fig. 2 is a schematic drawing of the manufacture equipment for a large-area perovskite film according to a second embodiment of the present invention.

### List of Reference Numerals

| | | | | | |
|---|---|---|---|---|---|
| 1: | vacuum chamber | 2: | substrate heater | 3: | first evaporation case |
| 31: | first carrier-gas pipe | 4: | second evaporation case | | |
| 41: | second carrier-gas pipe | 42: | gas pipe | 5: | first heater |
| 6: | second heater | 7: | damper | 8: | film thickness gauge |
| 9: | orifice plate | 91: | first gas pore | 92: | second gas pore |
| 11: | first gas preheater | 12: | second gas preheater | | |
| 13: | first raw material heating box | 14: | second raw material heating box | | |
| 15: | first raw material feeding mechanism | | | | |
| 16: | second raw material feeding mechanism | 17. | heat-tracing heater | | |

### DETAILED DESCRIPTION OF PREFERRED EMBODIMENTS OF THE IVENTION

The present invention will be further described with reference to specific embodiments. The drawings are all simplified schematic drawings illustrating the basic structure of the invention by way of example and showing only components relevant to the present invention.

### First Embodiment

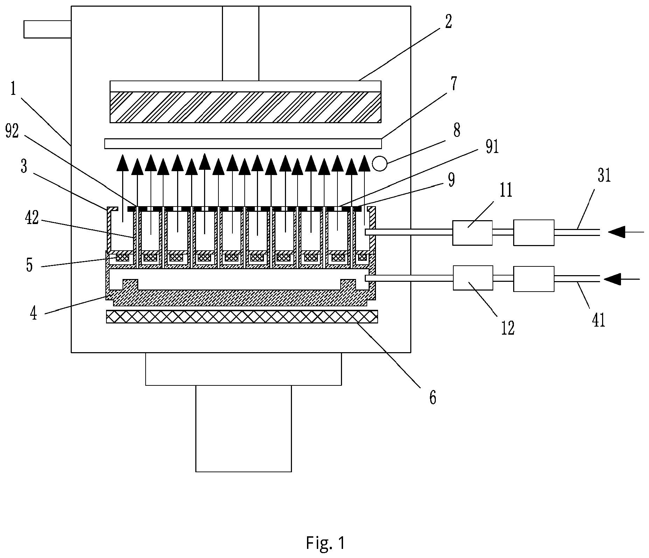

As shown in Fig. 1, a manufacture equipment for a large-area perovskite film comprises a vacuum chamber 1 which is a cavity within a vacuum box. A substrate heater 2 for heating a substrate is provided inside vacuum chamber 1. The substrate, such as glass, PET film, PI film, or stainless steel sheet, is clamped on the substrate heater and deposition is performed upwardly. Alternatively, a roller is provided under the substrate heater and the substrate is moved slowly on the roller so as to form a chain-type deposition equipment.

A first evaporation case 3 and a second evaporation case 4 are disposed under substrate heater 2 in vacuum chamber 1. First evaporation case 3 has an open upper end, and second evaporation case 4 is provided with a plurality of gas pipes 42 vertically disposed on an upper end surface thereof. First evaporation case 3 is embedded above second evaporation case 4, and upper ends of respective gas pipes 42 penetrate through a bottom surface of first evaporation case 3 and protrude in first evaporation case 3. A damper 7 which can be opened and closed is disposed between first evaporation case 3 and substrate heater 2. Damper 7 has a common connection structure. For example, damper 7 can be opened or closed by way of hinge connection.

A first heater 5 is disposed on the bottom of first evaporation case 3 for heating the bottom surface of first evaporation case 3. First evaporation case 3 is connected with a first carrier-gas pipe 31 communicating with an external carrier-gas source. A second heater 6 is disposed on a bottom of second evaporation case 4 for heating the bottom surface of second evaporation case 4, and second evaporation case 4 is connected with a second carrier-gas pipe 41 communicating with an external carrier-gas source.

A first gas preheater 11 is provided on the pipeline of first carrier-gas pipe 31, and a second gas preheater 12 is provided on the pipeline of second carrier-gas pipe 41.

The gas preheater includes a metal heating body having a gas stream channel of Peano curve configuration therein. With this structure, the gas in the carrier-gas pipe can be pre-heated sufficiently.

In order to mix the two evaporation gases uniformly, an orifice plate 9 is provided above the opened upper end of the first evaporation case 3. Orifice plate 9 is formed with a plurality of first gas pores 91 and a plurality of second gas pores 92 respectively. First gas pores 91 are provided for evaporated first solid evaporation source passing, and second gas pores 92 are provided for evaporated second evaporation source passing. First gas pore 91 and second gas pore 92 are spaced apart and arranged alternately. The upper ends of respective gas pipes 42 of second evaporation case 4 are connected with second gas pores 92.

A vacuum pump set is provided under vacuum chamber 1. The vacuum pump set is communicating with an internal cavity of vacuum chamber 1 and a butterfly valve is disposed at an inlet of the vacuum pump set. A film thickness gauge 8 is disposed inside vacuum chamber 1 for measuring the thickness of the substrate. Two gas-carrier pipes are each provided with a mass flow meter thereon.

In the present embodiment, the first solid evaporation source fed to first evaporation case 3 is methylamine iodine powder, and the second solid evaporation source fed to second evaporation case 4 is lead iodide and/or lead chloride. First evaporation case 3 is removably embedded above second evaporation case 4 to facilitate feeding evaporation source. First evaporation case 3 is made of stainless steel No. 316. The bottom of second evaporation case 4 is composed of a Quartz loading tank. The second heater 6 heats the Quartz loading tank.

When an operation is started, firstly, places the substrate on the heater, for example, the substrate can be fixed on the heater by way of clamping; lays lead iodide powder evenly on the Quartz loading tank of second evaporation case 4, and lays methyl amine iodine power evenly on the bottom of first evaporation case 3; then starts the vacuum pump set to pump until the vacuum degree is below 1E-5Pa;

Secondly, turns on substrate heater 2 until the temperature reaches 80 degree centigrade and maintains 3-5 minutes; turns on the two gas preheaters to heat the carrier-gas pipes; argon gas is immitted at 100 sccm for the two carrier-gases; controls the butterfly valve to maintain a pressure of about 50Pa within the vacuum chamber.

Thirdly, turns on second heater 6, controls the heating temperature to be 320 degree centigrade until the temperature is stable; then turns on a heater of first heater 5, controls the heating temperature to be 100 degree centigrade until the temperature is stable.

Fourthly, damper 7 is opened, then two kinds of evaporation source vapor is carried by the carrier-gas to be sprayed on the substrate and then reacts each other to generate a perovskite film. The film thickness is controlled by use of film thickness gauge 8 or controlled by time.

Finally, all the heaters are turned off, and the vacuum is released, and the manufactured film is picked out.

### Second embodiment

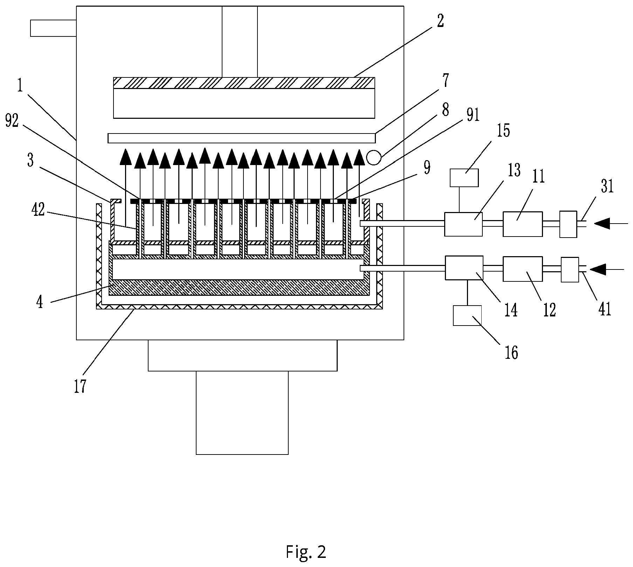

As shown in Fig. 2, a manufacture equipment for a large-area perovskite film comprises a vacuum chamber 1 which is a cavity within a vacuum box. A substrate heater 2 for heating a substrate is provided inside the vacuum chamber 1. The substrate is made of materials such as glass, PET film, PI film, stainless steel sheet and so on. When being mounted, the substrate can be clamped on the substrate heater and the deposition will be performed upwardly. Alternatively, a roller is provided under the substrate heater and the substrate is moved slowly on the roller to form a chain-type deposition equipment.

A first evaporation case 3 and a second evaporation case 4 are disposed under the substrate heater 2 in vacuum chamber 1. First evaporation case 3 has an open upper end, and second evaporation case 4 is provided with a plurality of gas pipes 42 vertically disposed on an upper end surface thereof. First evaporation case 3 is embedded above second evaporation case 4, and the upper ends of respective gas pipes 42 penetrate through a bottom surface of first evaporation case 3 and protrude in first evaporation case 3. A damper 7 which can be opened and closed is disposed between first evaporation case 3 and substrate heater 2. Damper 7 has a common connection structure. For example, damper 7 can be opened or closed by way of hinge connection.

First evaporation case 3 is connected with a first carrier-gas pipe 31 communicating with an external carrier-gas source. A first raw material heating box 13 is provided on pipeline of first carrier-gas pipe 31, and first raw material heating box 13 is connected with a first raw material feeding mechanism 15. A second raw material heating box 14 is provided on pipeline of second carrier-gas pipe 41, and second raw material heating box 14 is connected with a second raw material feeding mechanism 16. The raw material feeding mechanisms serve for feeding raw materials to the raw material boxes. First raw material feeding mechanism 15 adds the first solid evaporation source to first raw material box 13, and second raw material feeding mechanism 16 adds the second solid evaporation source to second raw material box 14.

A gas preheater includes a metal heating body having a gas stream channel of Peano curve configuration therein. When gas streams pass through this structure, the gas in the carrier-gas pipe can be preheated sufficiently.

A first gas preheater 11 is provided on first carrier-gas pipe 31 which lies upstream of first raw material heating box 13, and a second gas preheater 12 is provided on second carrier-gas pipe 41 which lies upstream of second raw material heating box 14. Further, a heat-tracing heater 17 is disposed inside vacuum chamber 1. Heat-tracing heater 17 is provided surrounding the outside of first evaporation case 3 and second evaporation case 4. Heat-tracing heater 17 serves to maintain the temperature inside the two evaporation cases.

In order to mix the two kinds of evaporation gas evenly, an orifice plate 9 is provided above the opened upper end of first evaporation case 3. Orifice plate 9 is formed with a plurality of first gas pores 91 and a plurality of second gas pores 92 respectively. First gas pores 91 are provided for evaporated first solid evaporation source passing, and second gas pores 92 are provided for evaporated second evaporation source passing. First gas pore 91 and second gas pore 92 are spaced apart and arranged alternately. The upper ends of respective gas pipes 42 of second evaporation case 4 are connected with second gas pores 92.

A vacuum pump set is provided under vacuum chamber 1. The vacuum pump set is communicating with an internal cavity of vacuum chamber 1 and a butterfly valve is disposed at an inlet of the vacuum pump set. A film thickness gauge 8 is disposed inside vacuum chamber 1 for measuring the thickness of the substrate.

When an operation is started, firstly, places the substrate on the heater, for example, the substrate can be fixed on the heater by way of clamping, then starts the vacuum pump set to pump until the vacuum degree is below 1E-5Pa;

Secondly, turns on substrate heater 2 until the temperature reaches 80 degree centigrade and maintains 3-5 minutes, then turns on the two gas preheaters to heat the carrier-gas pipes, wherein the first preheater increases temperature up to 100 degree centigrade, and the second preheater increases temperature up to 320 degree centigrade, then argon gas is immitted at 100 sccm as the two carrier-gases, and controls the butterfly valve to maintain a pressure of about 50Pa within the vacuum chamber.

Thirdly, turns on second raw material heating box 14, then a heating plate inside second raw material heating box 14 begins heating. Controls heating temperature to be 320 degree centigrade until the temperature is stable. Thereafter turns on first raw material heating box 13, then a heating plate inside first raw material heating box 13 will begin heating. Controls the heating temperature to be 100 degree centigrade until the temperature is stable. Second raw material feeding mechanism 16 feeds a suitable amount of lead iodid powder onto a heating plate inside second raw material heating box 14 and the amount of raw material to be fed is suitably adjusted as per the consumption of the raw material. First raw material feeding mechanism 15 feeds and lays a suitable amount of methyl amine iodine powder evenly onto a heating plate inside first raw material heating box 13 and the amount of raw material to be fed is suitably adjusted as per the consumption of the raw material.

Fourthly, the argon gas carries two the kinds of evaporation source vapor entering the respective evaporation cases. Heat-tracing heater 17 heats and controls the temperature inside the two evaporation cases. The working temperature of heat-tracing heater 17 is controlled at about 80 degree. The two kinds of carrier-gases are discharged via orifice plate 9 toward the lower side of damper 7 after heat-tracing.

Fifthly, when it is stable, damper 7 is opened, and the two kinds of evaporation source vapor are carried by argon gas to be sprayed onto the substrate and then reacts each other to generate perovskite film. The film thickness can be controlled by use of film thickness gauge 8 or controlled by time.

Finally, all the heaters are turned off, the vacuum is released, and the manufactured film is picked out.

The scope of the present invention should not be limited by the contents described in the specification, but be defined by the claims.

## Claims

1. A manufacture equipment for a large-area perovskite film, wherein
the equipment comprises a vacuum chamber (1) provided with a substrate heater (2) therein for accommodating a substrate;
a first evaporation case (3) and a second evaporation case (4) are disposed under the substrate heater (2) in the vacuum chamber (1), the first evaporation case (3) has an open upper end, the second evaporation case (4) is provided with a plurality of gas pipes (42) vertically disposed on an upper end surface thereof, the first evaporation case (3) is embedded above the second evaporation case (4), the upper ends of the respective gas pipes penetrate through a bottom surface of the first evaporation case (3) and protrude inside the first evaporation case (3), and a damper (7) is disposed between the first evaporation case (3) and the substrate heater (2) to be opened and closed,
the first evaporation case (3) is connected with a first carrier-gas pipe (31) communicating with an external carrier-gas source; a first raw material heating box (13) is provided on the first carrier-gas pipe (31), and the first raw material heating box (13) is connected with a first raw material feeding mechanism (15); a second raw material heating box (14) is provided on the second carrier-gas pipe (41), and the second raw material heating box (14) is connected with a second raw material feeding mechanism (16); the raw material feeding mechanisms serve for feeding raw materials to the raw material boxes,
a heat-tracing heater (17) is disposed inside the vacuum chamber (1), the heat-tracing heater (17) is provided alone surrounding, in a conformal manner, sidewalls and bottom of the first evaporation case (3) and the second evaporation case (4).

2. The manufacture equipment for a large-area perovskite film according to claim 1, wherein a first gas preheater (11) is provided on the pipeline of the first carrier-gas pipe (31), and a second gas preheater (12) is provided on the pipeline of the second carrier-gas pipe (41).

3. The manufacture equipment for a large-area perovskite film according to claim 2, wherein the gas preheaters each includes a metal heating body which has a gas stream channel of Peano curve configuration therein.

4. The manufacture equipment for a large-area perovskite film according to claim 1, wherein an orifice plate (9) is provided above the opened upper end of the first evaporation case (3), the orifice plate (9) is formed with a plurality of first gas pores (91) and a plurality of second gas pores (92) respectively, the first gas pores (91) are provided for evaporated first solid evaporation source passing, the second gas pores (92) are provided for evaporated second evaporation source passing, each the first gas pore (91) and the second gas pore (92) are spaced apart and arranged alternately; the upper ends of the respective gas pipes (42) of the second evaporation case (4) are connected with the second gas pores (92).

5. The manufacture equipment for a large-area perovskite film according to claim 1, wherein
a vacuum pump set is provided under the vacuum chamber (1), the vacuum pump set is communicating with an internal cavity of the vacuum chamber (1) and a butterfly valve is disposed at an inlet of the vacuum pump set; and
a film thickness gauge (8) is disposed inside the vacuum chamber (1) for measuring the thickness of the substrate.

## Patentansprüche

1. Vorrichtung zur Herstellung eines großflächigen Perowskitfilms, wobei
die Vorrichtung eine Vakuumkammer (1) umfasst, die mit einem Substratheizer (2) zur Aufnahme eines Substrats versehen ist;
ein erster Verdampfungskasten (3) und ein zweiter Verdampfungskasten (4) unter dem Substratheizer (2) in der Vakuumkammer (1) angeordnet sind, der erste Verdampfungskasten (3) ein offenes oberes Ende hat, der zweite Verdampfungskasten (4) mit einer Vielzahl von Gasleitungen (42) versehen ist, die vertikal an einer oberen Endfläche davon angeordnet sind, der erste Verdampfungskasten (3) oberhalb des zweiten Verdampfungskastens (4) eingebettet ist, die oberen Enden der jeweiligen Gasleitungen eine Bodenfläche des ersten Verdampfungskastens (3) durchdringen und in das Innere des ersten Verdampfungskastens (3) hineinragen, und eine Ablenkplatte (7) zwischen dem ersten Verdampfungskasten (3) und dem Substratheizer (2) zum Öffnen und Schließen angeordnet ist,
der erste Verdampfungskasten (3) mit einem ersten Trägergasrohr (31) verbunden ist, das mit einer externen Trägergasquelle in Verbindung steht; ein erster Rohstoff-Heizkasten (13) an dem ersten Trägergasrohr (31) vorgesehen ist und der erste Rohstoff-Heizkasten (13) mit einem ersten Rohstoff-Fütterungsmechanismus (15) verbunden ist; ein zweiter Rohstoff-Heizkasten (14) an dem zweiten Trägergasrohr (41) vorgesehen ist, und der zweite Rohstoff-Heizkasten (14) mit einem zweiten Rohmaterial-Fütterungsmechanismus (16) verbunden ist; die Rohstoff-Fütterungsmechanismus zum Zuführen von Rohmaterialien zu den Rohstoffkästen dienen,
ein Begleitheizer (17) im Inneren der Vakuumkammer (1) angeordnet ist, der Begleitheizer (17) in einem einzigen Stück vorgesehen ist und die Seitenwände und den Boden des ersten Verdampfungskastens (3) und des zweiten Verdampfungskastens (4) auf konforme Art und Weise umgibt.

2. Vorrichtung zur Herstellung eines großflächigen Perowskitfilms nach Anspruch 1, wobei ein erster Gas-Vorheizer (11) an dem ersten Trägergasrohr (31) und ein zweiter Gas-Vorheizer (12) an dem zweiten Trägergasrohr (41) vorgesehen ist.

3. Vorrichtung zur Herstellung eines großflächigen Perowskitfilms nach Anspruch 2, wobei die Gas-Vorheizer jeweils einen metallischen Heizkörper aufweisen, der einen Gasstromkanal mit Peano-Kurvenkonfiguration darin hat.

4. Vorrichtung zur Herstellung eines großflächigen Perowskitfilms nach Anspruch 1, wobei über dem geöffneten oberen Ende des ersten Verdampfungskastens (3) eine perforierte Platte (9) vorgesehen ist, die mit einer Vielzahl von ersten Gasöffnungen (91) bzw. einer Vielzahl von zweiten Gasöffnungen (92) ausgebildet ist, die ersten Gasöffnungen (91) für den Durchgang der verdampften ersten Feststoffverdampfungsquelle vorgesehen sind, die zweiten Gasöffnungen (92) für den Durchgang der verdampften zweiten Verdampfungsquelle vorgesehen sind, die ersten Gasöffnungen (91) und die zweiten Gasöffnungen (92) jeweils voneinander beabstandet und abwechselnd angeordnet sind; die oberen Enden der jeweiligen Gasleitungen (42) des zweiten Verdampfungskastens (4) mit den zweiten Gasöffnungen (92) verbunden sind.

5. Vorrichtung zur Herstellung eines großflächigen Perowskitfilms nach Anspruch 1, wobei
ein Vakuumpumpensatz unter der Vakuumkammer (1) vorgesehen ist, der Vakuumpumpensatz mit einem inneren Hohlraum der Vakuumkammer (1) in Verbindung steht und ein Drosselventil an einem Einlass des Vakuumpumpensatzes angeordnet ist; und
ein Filmdickenmessgerät (8) innerhalb der Vakuumkammer (1) angeordnet ist, um die Dicke des Substrats zu messen.

## Revendications

1. Équipement de fabrication d'un film de pérovskite de grande surface, dans lequel
l'équipement comprend une chambre à vide (1) pourvue d'un réchauffeur de substrat (2) destiné à recevoir un substrat;
un premier boîtier d'évaporation (3) et un deuxième boîtier d'évaporation (4) sont disposés sous le réchauffeur de substrat (2) dans la chambre à vide (1), le premier boîtier d'évaporation (3) a une extrémité supérieure ouverte, le deuxième boîtier d'évaporation (4) est pourvu d'une pluralité de conduites de gaz (42) disposées verticalement sur une surface d'extrémité supérieure de celles-ci, le premier boîtier d'évaporation (3) est encastré au-dessus du deuxième boîtier d'évaporation (4), les extrémités supérieures des conduites de gaz respectives pénètrent à travers une surface inférieure du premier boîtier d'évaporation (3) et font saillie à l'intérieur du premier boîtier d'évaporation (3), et une plaque déflectrice (7) est disposée entre le premier boîtier d'évaporation (3) et le réchauffeur de substrat (2) pour être ouverte et fermée,
le premier boîtier d'évaporation (3) est relié à un premier tuyau de gaz porteur (31) communiquant avec une source de gaz porteur externe; une première boîte de chauffage de matière première (13) est prévue sur le premier tuyau de gaz porteur (31), et la première boîte de chauffage de matière première (13) est reliée à un premier mécanisme d'alimentation en matière première (15); une deuxième boîte de chauffage de matière première (14) est prévue sur le deuxième tuyau de gaz porteur (41), et la deuxième boîte de chauffage de matière première (14) est reliée à un deuxième mécanisme d'alimentation en matière première (16); les mécanismes d'alimentation en matières premières permettent d'alimenter des boîtes de matières premières en matières premières,
un réchauffeur à traçage (17) est disposé à l'intérieur de la chambre à vide (1), le réchauffeur à traçage (17) est prévu en une seule pièce entourant, de manière conforme, les parois latérales et le fond du premier boîtier d'évaporation (3) et du deuxième boîtier d'évaporation (4).

2. Équipement de fabrication d'un film de pérovskite de grande surface selon la revendication 1, dans lequel un premier préchauffeur de gaz (11) est prévu sur le premier tuyau de gaz porteur (31), et un deuxième préchauffeur de gaz (12) est prévu sur le deuxième tuyau de gaz porteur (41).

3. Équipement de fabrication d'un film de pérovskite de grande surface selon la revendication 2, dans lequel les préchauffeurs de gaz comprennent chacun une pièce chauffante métallique dans laquelle se trouve un canal de flux de gaz à configuration de courbe de Peano.

4. Équipement de fabrication d'un film de pérovskite de grande surface selon la revendication 1, dans lequel une plaque perforée (9) est prévue au-dessus de l'extrémité supérieure ouverte du premier boîtier d'évaporation (3), la plaque perforée (9) est pourvue d'une pluralité de premiers évents à gaz (91) et d'une pluralité de deuxièmes évents à gaz (92) respectivement, les premiers évents à gaz (91) sont prévus pour le passage de la première source d'évaporation solide qui a été évaporée, les deuxièmes évents à gaz (92) sont prévus pour le passage de la deuxièmee source d'évaporation solide qui a été évaporée, les premiers évents à gaz (91) et les deuxièmes évents à gaz (92) sont espacés l'un par l'autre et disposés en alternance; les extrémités supérieures des conduites de gaz respectives (42) du deuxième boîtier d'évaporation (4) sont reliées aux deuxièmes évents à gaz (92).

5. Équipement de fabrication d'un film de pérovskite de grande surface selon la revendication 1, dans lequel
un ensemble de pompes à vide est prévu sous la chambre à vide (1), l'ensemble de pompes à vide communique avec une cavité interne de la chambre à vide (1) et une vanne papillon est disposée à l'entrée de l'ensemble de pompes à vide; et
une jauge d'épaisseur de film (8) est disposée à l'intérieur de la chambre à vide (1) pour mesurer l'épaisseur du substrat.
